# EUROPEAN PATENT APPLICATION

(11) **EP 4 826 394 A1**
(43) Date of publication of application: **21.10.2026**
(21) Application number: 24903459.6
(22) Date of filing: 21.11.2024
(51) Int. Cl.: G01R 1/06, G01R 1/067, G01R 31/26, H01L 21/66

(54) **ELECTRICAL CONNECTION DEVICE**

(30) Priority: 12.12.2023 JP 2023209369
(71) Applicant: Kabushiki Kaisha Nihon Micronics, Musashino-shi Tokyo 180-8508 (JP)
(72) Inventor: FUKUSHI, Naoki, Musashino-shi, Tokyo 180-8508 (JP); MATSUO, Takuya, Musashino-shi, Tokyo 180-8508 (JP); TAKAHASHI, Masayuki, Musashino-shi, Tokyo 180-8508 (JP); OMORI, Toshinori, Musashino-shi, Tokyo 180-8508 (JP); NARA, Yuto, Musashino-shi, Tokyo 180-8508 (JP)
(74) Representative: Berggren Oy
(86) International application number: PCT/JP2024/041356
(87) International publication number: WO 2025/126800

(57) **Abstract**

An electrical connection device (100) includes: a probe (10) including a columnar body portion (11) extending in an axial direction and a base end portion (13) connected to the body portion (11); and a substrate (20) having a land (21) disposed on a first surface (201) positioned opposite to the base end portion (13) of the probe (10), the land (21) being electrically connected to the base end portion (13). The base end portion (13) of the probe (10) includes a plurality of connection portions (130) each having a connecting portion (131) having one end connected to the body portion (11) and a contact portion (132) connected to the other end of the connecting portion (131). The substrate (20) has a land group (210) including a plurality of lands (21) that individually come into contact with each of a plurality of contact portions (132) included in a same base end portion (13).

## Description

### TECHNICAL FIELD

The present invention relates to an electrical connection device used for inspection of electrical characteristics of an inspection object.

### BACKGROUND ART

An electrical connection device including a probe is used for inspection of electrical characteristics of an inspection object such as a semiconductor integrated circuit in a wafer state. In inspection using a probe, one end of the probe comes into contact with an electrode of the inspection object, and the other end of the probe comes into contact with a terminal (hereinafter referred to as "land") disposed on a substrate included in the electrical connection device. The land is electrically connected to an inspection device such as a tester.

### CITATION LIST

### PATENT LITERATURE

Patent Literature 1: Japanese Patent Application Publication No. 2018-4260

### SUMMARY

In order to accurately inspect the electrical characteristics of an inspection object, it is necessary to stably electrically connect the inspection object and the land via a probe. An object of the present invention is to provide an electrical connection device capable of establishing a stable electrical connection between an inspection object and a land.

An electrical connection device according to an aspect of the present invention includes: a probe including a columnar body portion extending in an axial direction and a base end portion connected to the body portion; and a substrate having a land disposed on a first surface positioned opposite to the base end portion of the probe, the land being electrically connected to the base end portion. The base end portion of the probe includes a plurality of connection portions each having a connecting portion having one end connected to the body portion and a contact portion connected to the other end of the connecting portion. The substrate has a land group including a plurality of lands that individually come into contact with each of a plurality of contact portions included in a same base end portion.

The present invention makes it possible to provide an electrical connection device that stabilizes an electrical connection between an inspection object and a land.

### BRIEF DESCRIPTION OF DRAWINGS

[FIG. 1] FIG. 1 is a schematic diagram illustrating a configuration of an electrical connection device according to a first embodiment.
[FIG. 2] FIG. 2 is a schematic perspective view illustrating a configuration of a probe included in the electrical connection device according to the first embodiment.
[FIG. 3] FIG. 3 is a schematic perspective view illustrating a configuration of a base end portion of the probe illustrated in FIG. 2.
[FIG. 4] FIG. 4 is a schematic diagram illustrating an example of arrangement of connecting portions of the base end portion illustrated in FIG. 3.
[FIG. 5] FIG. 5 is a schematic diagram illustrating a configuration of an electrical connection device of a comparative example.
[FIG. 6] FIG. 6 is a schematic plan view illustrating an example of arrangement of lands of a substrate included in the electrical connection device according to the first embodiment.
[FIG. 7] FIG. 7 is a schematic cross-sectional view illustrating an example of arrangement of internal wiring of the substrate included in the electrical connection device according to the first embodiment.
[FIG. 8] FIG. 8 is a schematic cross-sectional view illustrating another example of arrangement of internal wiring of the substrate included in the electrical connection device according to the first embodiment.
[FIG. 9] FIG. 9 is a schematic cross-sectional view illustrating still another example of arrangement of internal wiring of the substrate included in the electrical connection device according to the first embodiment.
[FIG. 10] FIG. 10 is a schematic plan view illustrating an example of arrangement of surface wiring of the substrate included in the electrical connection device according to the first embodiment.
[FIG. 11] FIG. 11 is a schematic cross-sectional view illustrating an example of electrical connection between the surface wiring and an external electrode illustrated in FIG. 10.
[FIG. 12] FIG. 12 is a schematic plan view illustrating another example of arrangement of surface wiring of the substrate included in the electrical connection device according to the first embodiment.
[FIG. 13] FIG. 13 is a schematic plan view illustrating still another example of arrangement of surface wiring of the substrate included in the electrical connection device according to the first embodiment.
[FIG. 14] FIG. 14 is a schematic plan view illustrating still another example of arrangement of surface wiring of the substrate included in the electrical connection device according to the first embodiment.
[FIG. 15] FIG. 15 is a schematic diagram illustrating an example of a structure of connecting portions of the probe included in the electrical connection device according to the first embodiment.
[FIG. 16] FIG. 16 is a schematic diagram illustrating another example of a structure of connecting portions of the probe included in the electrical connection device according to the first embodiment.
[FIG. 17] FIG. 17 is a schematic diagram illustrating still another example of a structure of connecting portions of the probe included in the electrical connection device according to the first embodiment.
[FIG. 18] FIG. 18 is a schematic diagram illustrating still another example of a structure of connecting portions of the probe included in the electrical connection device according to the first embodiment.
[FIG. 19] FIG. 19 is a schematic diagram illustrating still another example of a structure of connecting portions of the probe included in the electrical connection device according to the first embodiment.
[FIG. 20] FIG. 20 is a schematic perspective view illustrating a configuration of a base end portion of a probe included in an electrical connection device according to a second embodiment.
[FIG. 21] FIG. 21 is a schematic diagram illustrating an example of arrangement of connecting portions of the base end portion illustrated in FIG. 20.
[FIG. 22] FIG. 22 is a schematic plan view illustrating an example of arrangement of lands of a substrate included in the electrical connection device according to the second embodiment.
[FIG. 23] FIG. 23 is a schematic plan view illustrating another example of arrangement of lands of the substrate included in the electrical connection device according to the second embodiment.
[FIG. 24] FIG. 24 is a schematic diagram illustrating a configuration of an electrical connection device according to another embodiment.

### DESCRIPTION OF EMBODIMENTS

Next, embodiments of the present invention will be described with reference to the drawings. In the following description of the drawings, the same or similar parts are denoted by the same or similar reference numerals. It should be noted, however, that the drawings are schematic and ratios of thicknesses of respective parts are different from actual ones. Moreover, it is a matter of course that parts having different dimensional relationships and ratios are also included between the drawings. The embodiments illustrated below exemplify devices and methods for embodying the technical idea of the present invention, and the embodiments of the present invention do not limit the material, shape, structure, arrangement, and the like of the constituent parts to those described below.

### (First Embodiment)

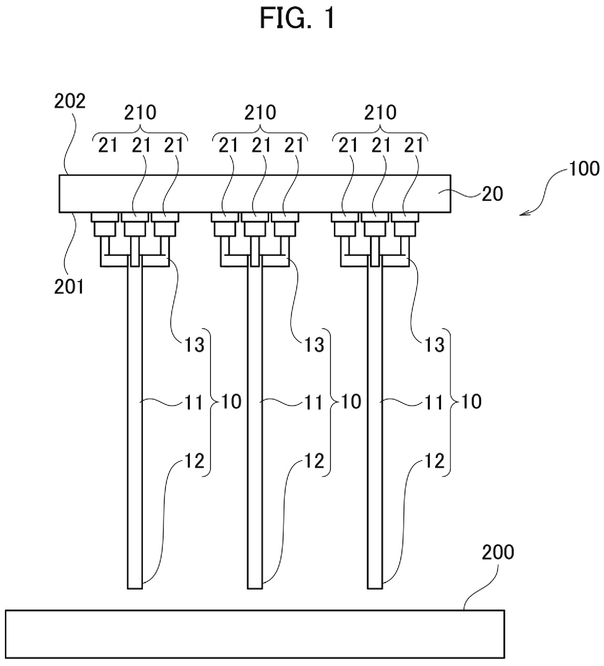

An electrical connection device 100 according to a first embodiment illustrated in FIG. 1 is used for inspection of electrical characteristics of an inspection object 200. The electrical connection device 100 includes probes 10, each probe 10 including a columnar body portion 11 and a base end portion 13 connected to the body portion 11, and a substrate 20 on which lands 21 electrically connected to the base end portions 13 of the probes 10 are disposed. The substrate 20 is, for example, a printed substrate or a space transformer. The lands 21 are disposed on the first surface 201 of the substrate 20 positioned opposite to the base end portions 13 of the probes 10.

Hereinafter, a direction in which the substrate 20 is positioned as viewed from the probes 10 is defined as upward, and a direction in which the probes 10 are positioned as viewed from the substrate 20 is defined as downward. In addition, a surface of each portion of the electrical connection device 100 facing upward is defined as an upper surface, a surface facing downward is defined as a lower surface, and a surface connecting the upper surface and the lower surface is defined as a side surface. For example, the first surface 201 is the lower surface of the substrate 20, and a second surface 202 is the upper surface of the substrate 20.

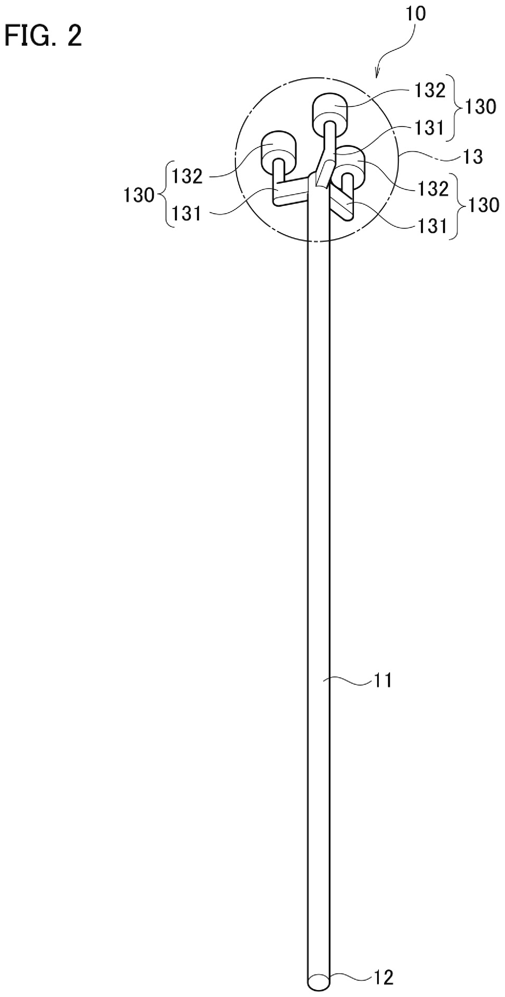

The probe 10 of the electrical connection device 100 will be described with reference to FIG. 2. The probe 10 illustrated in FIG. 2 includes the columnar body portion 11, a tip portion 12 connected to one end of the body portion 11 and coming into contact with the inspection object 200 in inspection, and the base end portion 13 connected to the other end of the body portion 11. Hereinafter, the axial direction in which the body portion 11 extends is also simply referred to as "axial direction". As illustrated in FIG. 2, the body portion 11 and the tip portion 12 may be integrally formed. The base end portion 13 includes a plurality of connection portions 130. Each of the connection portions 130 includes a connecting portion 131 with elasticity and connected to the body portion 11, and a contact portion 132 connected to the connecting portion 131.

Although in the probe 10 illustrated in FIG. 2, the base end portion 13 has three connection portions 130, the number of connection portions 130 included in the base end portion 13 may be two, or may be four or more. Hereinafter, a case where the base end portion 13 has three connection portions 130 as illustrated in FIG. 2 will be described as an example.

As illustrated in FIG. 2, the base end portion 13 of the probe 10 includes a plurality of connection portions 130 each having the connecting portion 131 having one end connected to the body portion 11 and the contact portion 132 connected to the other end of the connecting portion 131. Meanwhile, as illustrated in FIG. 1, the substrate 20 has land groups 210 each including the plurality of lands 21 that individually come into contact with each of the plurality of contact portions 132 included in the same base end portion 13. In the electrical connection device 100 including the plurality of probes 10, the substrate 20 has the plurality of land groups 210 corresponding to each of the plurality of probes 10.

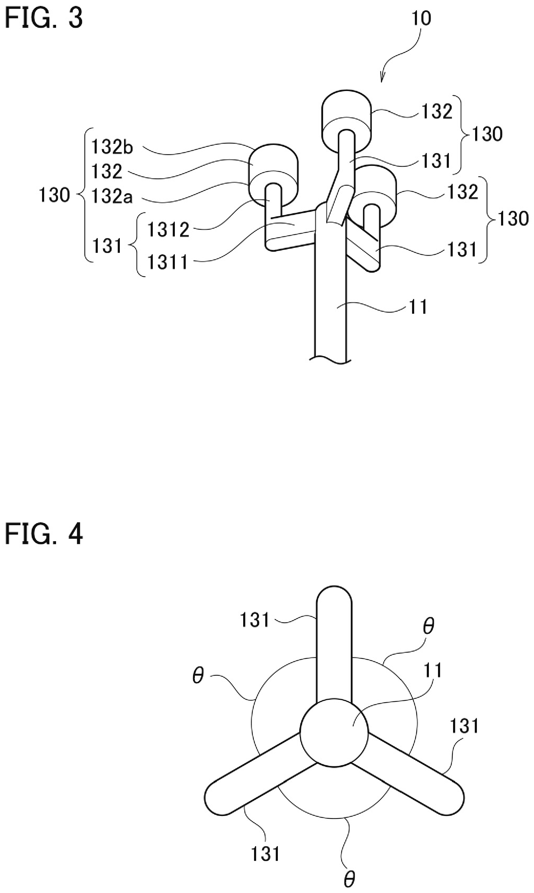

As illustrated in FIG. 3, the connecting portion 131 has a beam portion 1311 connected to the body portion 11 and extending in a direction perpendicular to the axial direction, and a support portion 1312 connected to the beam portion 1311 and extending in the axial direction. The first end 132a of the contact portion 132 is connected to the support portion 1312 of the connecting portion 131. The contact portion 132 extends parallel to the axial direction. When viewed from the axial direction, the body portion 11 and the contact portion 132 are disposed apart from each other. The second end 132b of the contact portion 132 is included in a planar level perpendicular to the axial direction at the position extended in the axial direction from the position of the other end of the body portion 11 to which the base end portion 13 is connected. The second end 132b of the contact portion 132 is connected to the land 21 in the inspection of the inspection object 200. The other end of the body portion 11 is positioned below the second end 132b of the contact portion 132, and a space is interposed between the end of the body portion 11 and the first surface 201 of the substrate 20. The contact between the land and the probe 10 becomes more stable as the diameter of the contact portion 132 increases. Although an example has been described in which the contact portion 132 has a larger diameter than the connecting portion 131, the contact portion 132 and the connecting portion 131 may have substantially the same diameter. In order to dispose the probes 10 at a narrow pitch, it is preferable for the diameter of the contact portion 132 to be small. Note that the end surface of the second end 132b of the contact portion 132 may be configured to remove an oxide film on the surface of the land. For example, unevenness may be formed on the end surface of the second end 132b.

The body portion 11 may have, for example, a circular shape or a polygonal shape in a cross section perpendicular to the axial direction (hereinafter, simply referred to as "cross section"). In the present embodiment, a case where the cross section of the body portion 11 has a circular shape will be described as an example. In order to electrically connect the electrode of the inspection object and the land 21, a conductive material such as a metal material is used for the probe 10. For example, nickel (Ni), nickel alloy, gold (Au), silver (Ag), copper (Cu), palladium (Pd), palladium alloy, rhodium (Rh), rhodium alloy, other noble metals, and the like may be used as the material of the probe 10.

During the inspection of the inspection object 200, the tip portion 12 of the probe 10 comes into contact with an electrode pad (not illustrated) of the inspection object 200. The connection portion 130 of the base end portion 13 of the probe 10 is connected to the land 21 of the substrate 20. Specifically, the second end 132b of the contact portion 132 is connected to the land 21. The land 21 is electrically connected to an inspection device such as an IC tester, which is not illustrated.

A tip of the second end 132b of the contact portion 132 may be a plane surface perpendicular to the axial direction of the probe 10. By forming the tip of the second end 132b as a plane surface, a contact area between the contact portion 132 and the land 21 can be increased. A larger current can flow through the probe 10 as the contact area between the contact portion 132 and the land 21 increases.

The electrical connection device 100 may be configured by bonding the base end portion 13 of the probe 10 to the land 21. A connection method and a connection material for bonding the probe 10 to the land 21 can be optionally selected. For example, the second end 132b of the contact portion 132 of the probe 10 may be bonded to the land 21 by soldering.

Since the connecting portion 131 of the connection portion 130 has elasticity, elastic deformation of the probe 10 along the axial direction is possible when bringing the tip portion 12 of the probe 10, in a state where the base end portion 13 is connected to the land 21, into contact with the inspection object 200. In other words, although the body portion 11 of the probe 10 is linear and thus does not have elasticity in the axial direction by itself, the probe 10 as a whole has elasticity in the axial direction. Therefore, after bringing the probe 10 into contact with the inspection object 200, an overdrive can be applied so as to press the probe 10 against the inspection object 200. The overdrive can ensure the electrical connection between the probe 10 and the inspection object 200. Further, since the base end portion 13 of the probe 10 has a plurality of contact portions 132, the probe 10 can be stably brought into contact with the land 21.

After the inspection of the inspection object 200 is completed, the probe 10 is separated from the inspection object 200. The connecting portion 131 is formed so that it elastically deforms and returns to its original state after the probe 10 is separated from the inspection object 200. For example, the connecting portion 131 may be made elastic by making the diameter of the beam portion 1311 of the connecting portion 131 relatively smaller than that of the body portion 11. Alternatively, the connecting portion 131 may be made elastic by using, for the connecting portion 131, a material having lower rigidity than that of the body portion 11. Further, as will be described later, a slit may be provided in the connecting portion 131.

As illustrated in FIG. 4, when viewed from the axial direction of the probe 10, an angle θ formed between adjacent connecting portions 131 may be the same for all of the adjacent connecting portions 131. For example, when the base end portion 13 has three connection portions 130, the angle θ is approximately 120 degrees. By making the plurality of connecting portions 131 extend from the body portion 11 such that the angle formed between them is equal, the probe 10 can be stably brought into contact with the land 21. For example, the posture of the probe 10 can be maintained perpendicular to the surface of the substrate 20 on which the land 21 is disposed. In addition, the plurality of connection portions 130 of the base end portion 13 come into contact with the land 21 with equal pressing force.

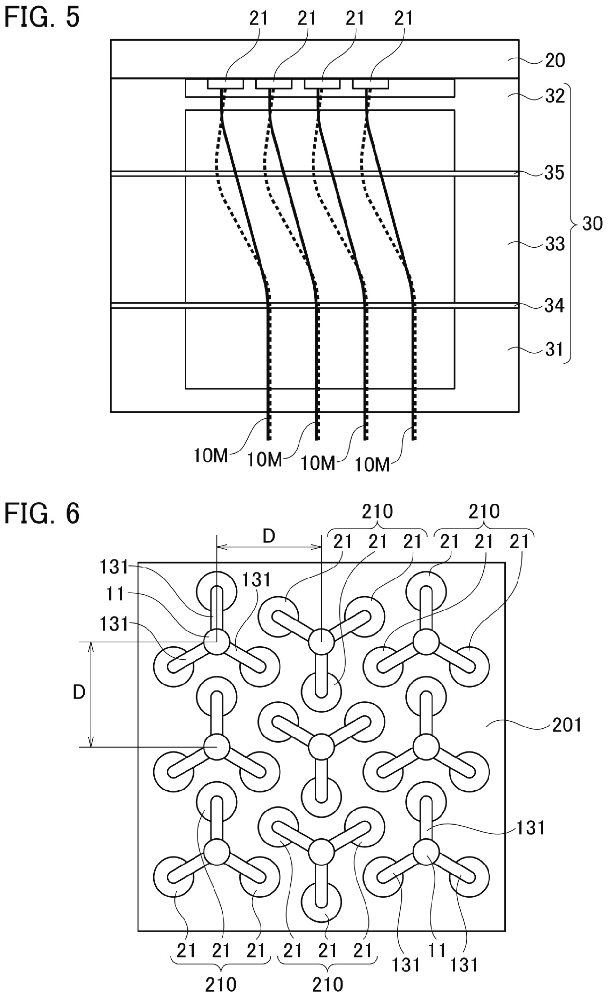

Meanwhile, a probe of a comparative example (hereinafter referred to as "comparative probe 10M") in which one end of a columnar body portion is used as a tip portion that comes into contact with an inspection object and the other end is connected to a land at one point of a base end portion does not have elasticity in the axial direction in the probe itself. Therefore, for example, as in the electrical connection device of the comparative example illustrated in FIG. 5, an overdrive is applied by curving the body portion of the comparative probe 10M.

In the electrical connection device of the comparative example illustrated in FIG. 5, the comparative probes 10M are held by a probe head 30 including a bottom-side guide plate 31 and a top-side guide plate 32. The bottom-side guide plate 31 is disposed around the tip portion of each of the comparative probes 10M. The top-side guide plate 32 is disposed around the base end portion of each of the comparative probes 10M. The probe head 30 further includes a first guide film 34 and a second guide film 35 that are disposed apart from each other in a space formed by interposing a spacer 33 between the top-side guide plate 32 and the bottom-side guide plate 31. The top-side guide plate 32 and the bottom-side guide plate 31 (hereinafter collectively referred to as "guide plates") are, for example, ceramic materials. The first guide film 34 and the second guide film 35 (hereinafter collectively referred to as "guide films") are, for example, resin films. The comparative probe 10M penetrates through guide holes (not illustrated) formed in the guide plates and the guide films.

In the probe head 30 illustrated in FIG. 5, with respect to the guide holes through which the same comparative probe 10M penetrates, an offset arrangement is made in which the position of the guide hole of the top-side guide plate 32 is shifted parallel to the main surface of the bottom-side guide plate 31 with respect to the guide hole of the bottom-side guide plate 31. Due to the offset arrangement, as illustrated by the solid line in FIG. 5, the body portions of the comparative probes 10M are curved inside the probe head 30. That is, in the hollow region between the bottom-side guide plate 31 and the top-side guide plate 32, the comparative probe 10M is in a curved state due to elastic deformation.

Since the guide plates are arranged in an offset manner, when the tip portion of the comparative probe 10M comes into contact with the inspection object, the comparative probe 10M buckles in the hollow region. That is, in a contact state where the comparative probe 10M is in contact with the inspection object, the comparative probe 10M is further curved by deflection deformation as illustrated by the broken line in FIG. 5. Since the comparative probe 10M is further curved, the comparative probe 10M comes into contact with the inspection object 200 with a predetermined pressure.

However, in the electrical connection device of the comparative example illustrated in FIG. 5, friction occurs between the comparative probe 10M and the guide plates and guide films due to the deformation of the comparative probe 10M. As a result, problems occur such as the comparative probe 10M not being able to sufficiently come into contact with the land 21 or the inspection object, resulting in insufficient electrical conduction between the inspection object and the land 21.

In contrast, the probe 10 does not need to be held in a state where the body portion 11 is curved. That is, there is no friction between the probe 10 and the guide plates and guide films, and thus the electrical conduction between the inspection object 200 and the land 21 is stabilized.

As described above, the electrical connection device 100 according to the embodiment is configured using the probe 10 including a plurality of connection portions 130 each having the contact portion 132 connected to the body portion 11 via the connecting portion 131. Therefore, according to the electrical connection device 100, the electrical connection between the inspection object 200 and the land 21 can be stabilized.

Further, in the electrical connection device 100 including the plurality of probes 10, the arrangement of the lands 21 on the first surface 201 of the substrate 20 can be set optionally. For example, as illustrated in FIG. 6, on the first surface 201 of the substrate 20, the plurality of lands 21 included in the land group 210 may be disposed apart from each other. FIG. 6 is a plan view of the first surface 201 of the substrate 20 as viewed from the axial direction. In addition, as illustrated in FIG. 6, between the lands 21 included in one land group 210, at least one land 21 included in another land group 210 adjacent to the one land group 210 may be disposed.

As illustrated in FIG. 6, in the electrical connection device 100, between the lands 21 included in the one land group 210, at least one land 21 included in another land group 210 can be disposed. Therefore, according to the electrical connection device 100, a distance D between the body portions 11 of the probes 10 can be reduced when viewed from the axial direction. In other words, the electrical connection device 100 in which the distance between the probes 10 is reduced can be configured.

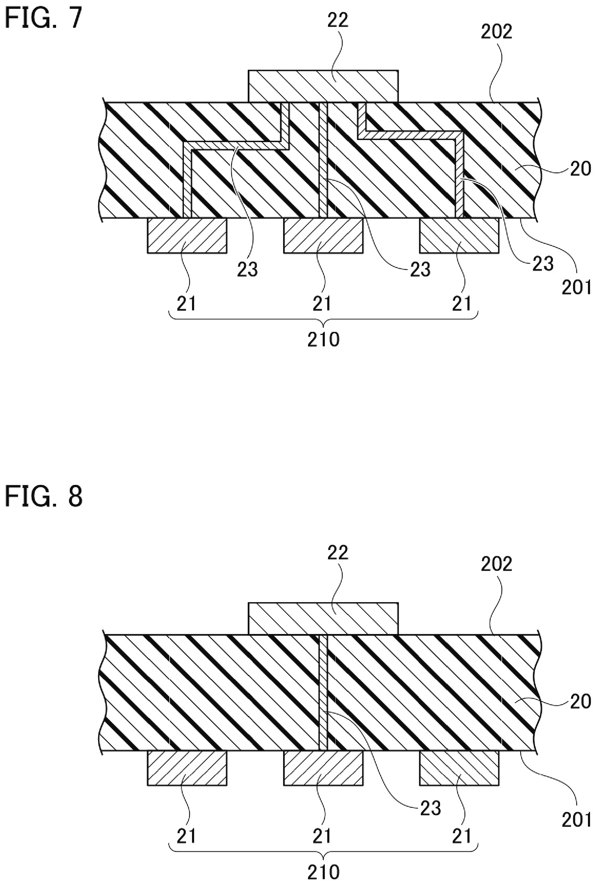

The substrate 20 includes an external electrode electrically connected to at least one land 21 included in the land group 210, corresponding to each of the land groups 210. For example, as illustrated in FIG. 7, an external electrode 22 is disposed on the second surface 202 of the substrate 20 facing in a direction opposite to the first surface 201. In the substrate 20 illustrated in FIG. 7, each of all the lands 21 included in the land group 210 is electrically connected to the external electrode 22 via an internal wiring 23 disposed inside the substrate 20.

Alternatively, as seen in the substrate 20 illustrated in FIG. 8, only one land 21 among a plurality of lands 21 included in the same land group 210 may be electrically connected to the external electrode 22 via the internal wiring 23. The configuration illustrated in FIG. 8 has a smaller allowable value of current flowing through the probe 10 than the configuration illustrated in FIG. 7. However, according to the substrate 20 having the configuration illustrated in FIG. 8, since the number of internal wirings 23 can be reduced, both the manufacture of the substrate 20 and the layout of the internal wirings 23 can be facilitated.

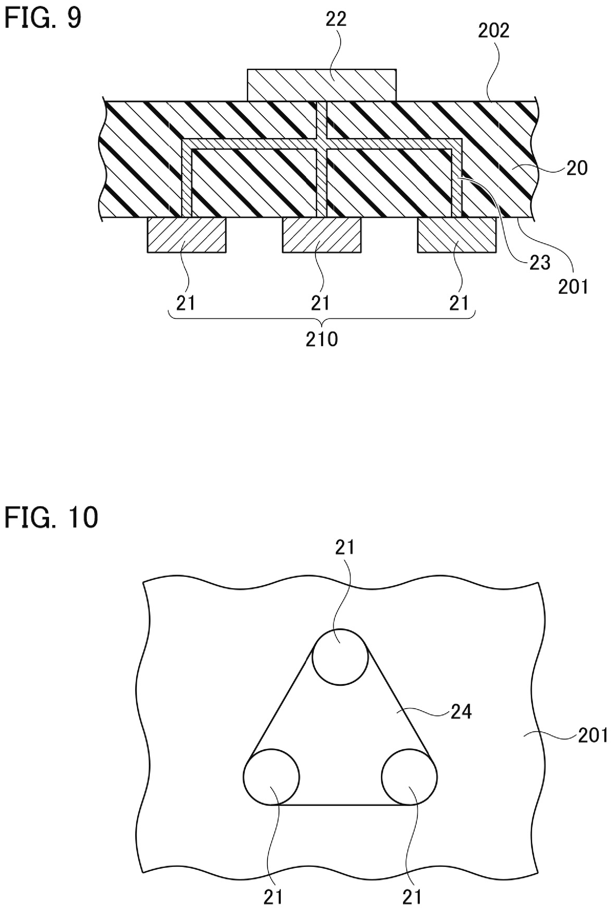

Further, as illustrated in FIG. 9, the plurality of lands 21 included in the land group 210 may be electrically connected to each other by the internal wiring 23 inside the substrate 20. That is, inside the substrate 20, the plurality of lands 21 included in the land group 210 may be electrically connected to each other.

As described above, the internal wiring 23 may be disposed in any manner as long as at least one land 21 included in the land group 210 and the external electrode 22 are electrically connected.

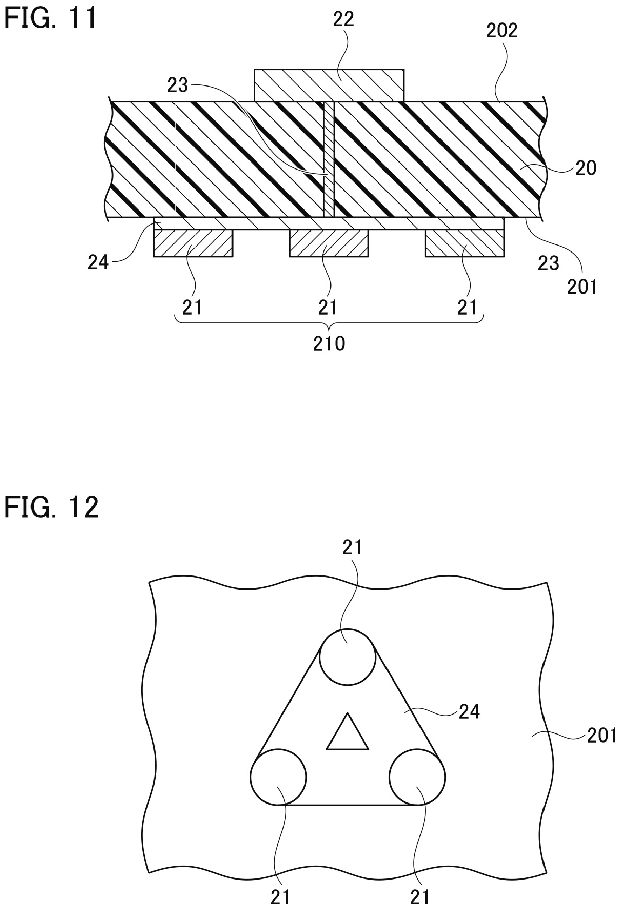

In FIG. 9, an example has been described in which the lands 21 included in the land group 210 are electrically connected to each other by the internal wiring 23 disposed inside the substrate 20. Meanwhile, as illustrated in FIG. 10, a conductive surface wiring 24 that electrically connects a plurality of lands 21 included in one land group 210 to each other may be disposed on the first surface 201 of the substrate 20. FIG. 10 illustrates an example in which all the lands 21 included in the land group 210 are disposed inside one surface wiring 24. As illustrated in FIG. 11, the surface wiring 24 may have a smaller thickness than the land 21. The surface wiring 24 is electrically connected to the external electrode 22 via the internal wiring 23, and thus the land 21 is electrically connected to the external electrode 22.

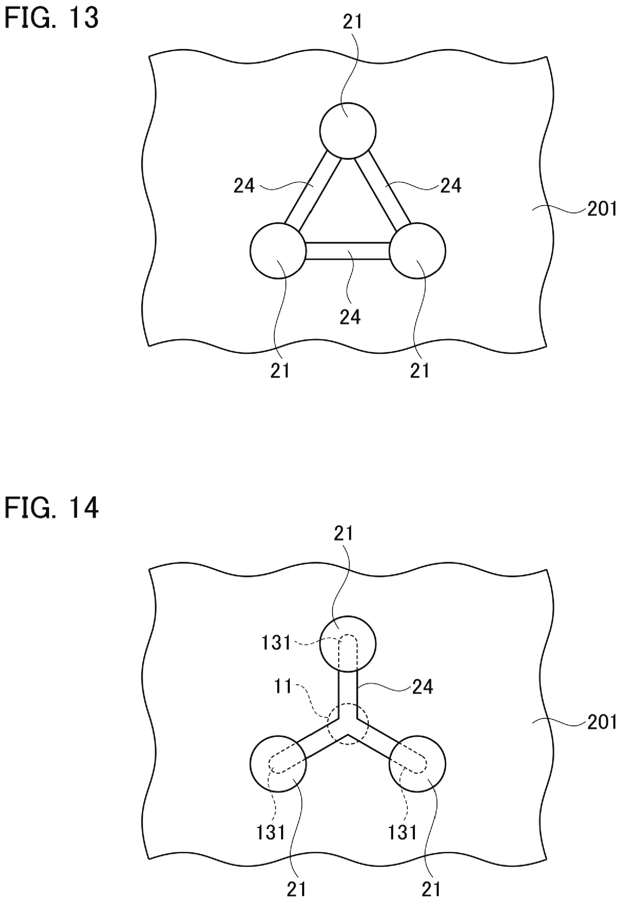

The width of the surface wiring 24 connecting between the lands 21 may be configured not to exceed the diameter of the land 21 when viewed from the normal direction of the first surface 201. For example, as illustrated in FIG. 12, the width of the surface wiring 24 perpendicular to a direction from one land 21 toward another adjacent land 21 may be made substantially the same as the diameter of the land 21. Alternatively, as illustrated in FIG. 13, the width of the surface wiring 24 connecting between the lands 21 may be made smaller than the diameter of the land 21. In other words, the surface wiring 24 may be configured not to exceed a straight line connecting outer edges of adjacent lands 21 included in the same land group 210 to each other.

Further, as illustrated in FIG. 14, the shape of the surface wiring 24 may be formed so as to overlap with the shape formed by the body portion 11 and the connecting portion 131 of the probe 10 when viewed from the normal direction of the first surface 201. The width of the surface wiring 24 between the lands 21 does not exceed the width of the connecting portion 131. By overlapping the positions of the body portion 11 and the connecting portion 131 with the position of the surface wiring 24, some lands 21 included in another land group 210 can be disposed between the lands 21 included in one land group 210. Therefore, the outer edge of the surface wiring 24 may be configured not to exceed the outer edges of the body portion 11 and the connecting portion 131 when viewed from the normal direction of the first surface 201.

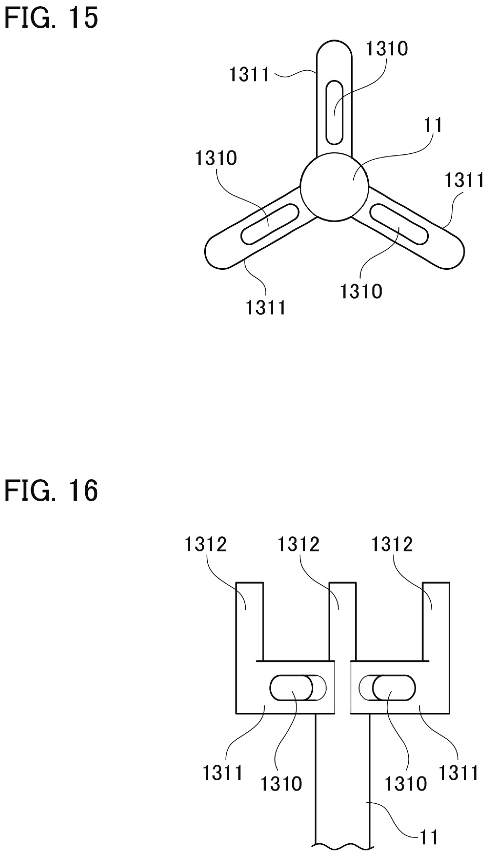

Various configurations can be adopted for the probe 10 in which the connecting portion 131 of the connection portion 130 has elasticity. For example, as illustrated in FIG. 15, the probe 10 may be used for the electrical connection device 100 in which a slit 1310 is formed in the connecting portion 131 of each of the plurality of connection portions 130. In the beam portion 1311, the slit 1310 penetrates through the connecting portion 131 in a direction parallel to the axial direction. According to the probe 10 illustrated in FIG. 15, by providing the slit 1310 penetrating from the upper surface to the lower surface in the beam portion 1311 of each connecting portion 131, a needle pressure at which the probe 10 comes into contact with the inspection object 200 (hereinafter also simply referred to as "needle pressure") can be adjusted.

Further, as illustrated in FIG. 16, the slit 1310 penetrating through the connecting portion 131 in the beam portion 1311 in a direction perpendicular to the axial direction may be formed in the connecting portion 131 of the probe 10. By providing the slit 1310 penetrating in the side surface direction in the beam portion 1311, the needle pressure can be adjusted.

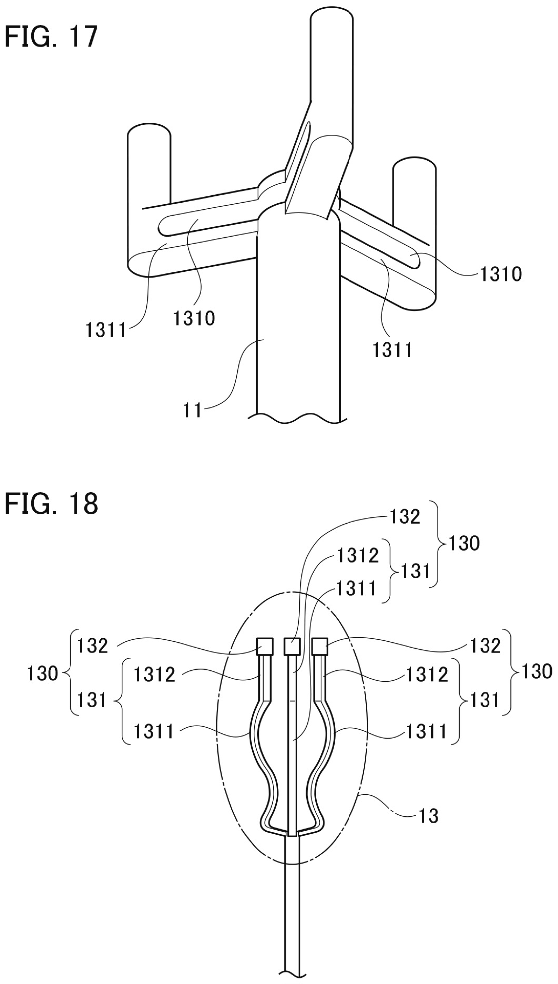

Alternatively, as illustrated in FIG. 17, the slits 1310 respectively formed in the beam portions 1311 of the plurality of connecting portions 131 may be in communication with each other at the portion where the connecting portion 131 is connected to the body portion 11. With the slits 1310 in communication with each other, the needle pressure can be adjusted by the plurality of connecting portions 131 as a whole.

As illustrated in FIG. 18, the connecting portion 131 of the probe 10 may include the beam portion 1311 that is connected to the body portion 11, and that has elasticity and is curved, and the support portion 1312 that connects the beam portion 1311 and the contact portion 132. In the probe 10 illustrated in FIG. 18, since the connecting portion 131 includes the curved portion, the connecting portion 131 is easily curved when the probe 10 comes into contact with the inspection object. Therefore, according to the probe 10 illustrated in FIG. 18, the overdrive can be applied more strongly. As a result, the probe 10 can be brought into contact with the inspection object more stably.

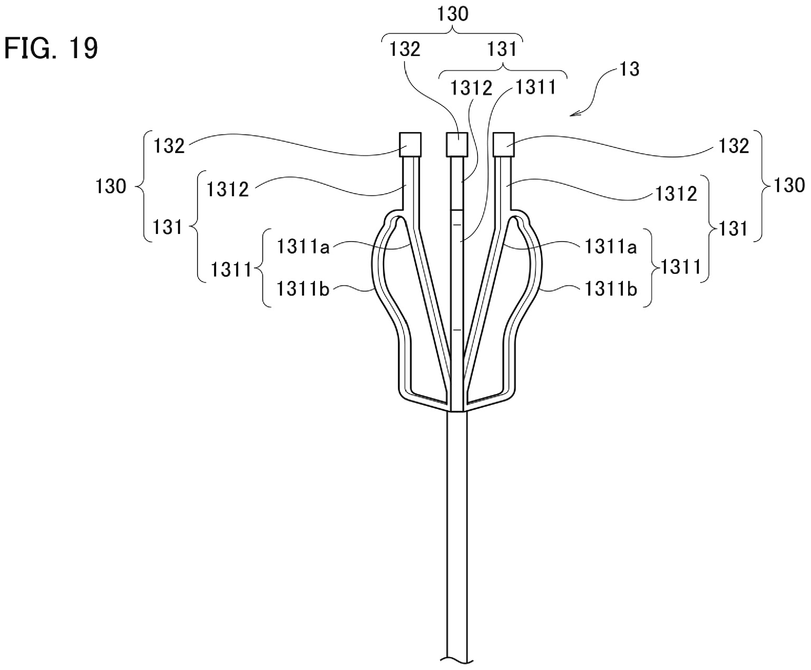

As illustrated in FIG. 19, the connecting portion 131 of the probe 10 may include a first arm 1311a and a second arm 1311b. The first arm 1311a and the second arm 1311b are disposed in parallel and are each connected to the body portion 11. The first arm 1311a linearly extends at an angle obliquely intersecting the axial direction in a direction away from the body portion 11. The second arm 1311b has a curved portion with elasticity. The contact portion 132 is connected to a joining portion where the first arm 1311a and the second arm 1311b are joined with each other. In the probe 10 illustrated in FIG. 19, since the second arm 1311b has a curved portion with elasticity, the connecting portion 131, which curves when the probe 10 comes into contact with the inspection object, has greater elasticity. As a result, the overdrive can be applied more strongly. Although FIG. 19 illustrates an example in which the connecting portion 131 includes the first arm 1311a and the second arm 1311b, the connecting portion 131 may be configured by three or more arms including at least one arm having a curved portion with elasticity.

### (Second Embodiment)

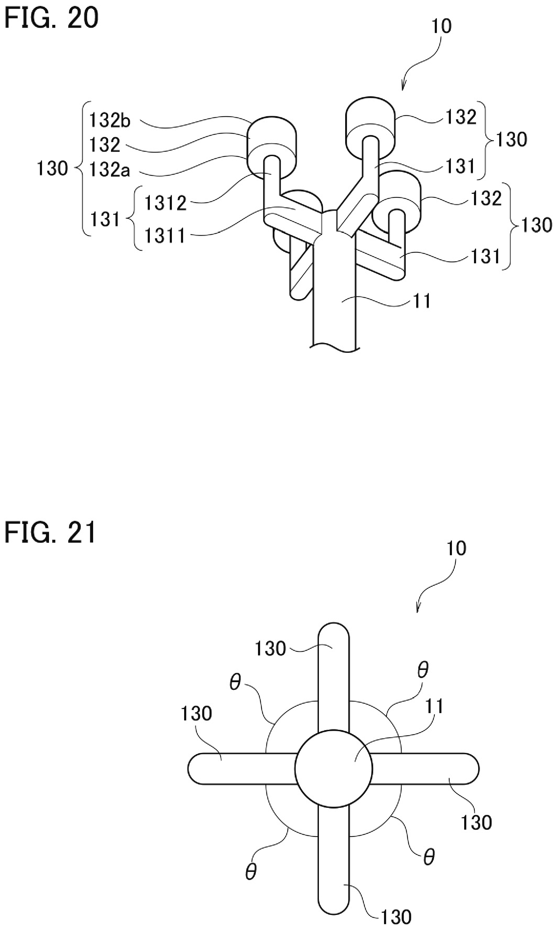

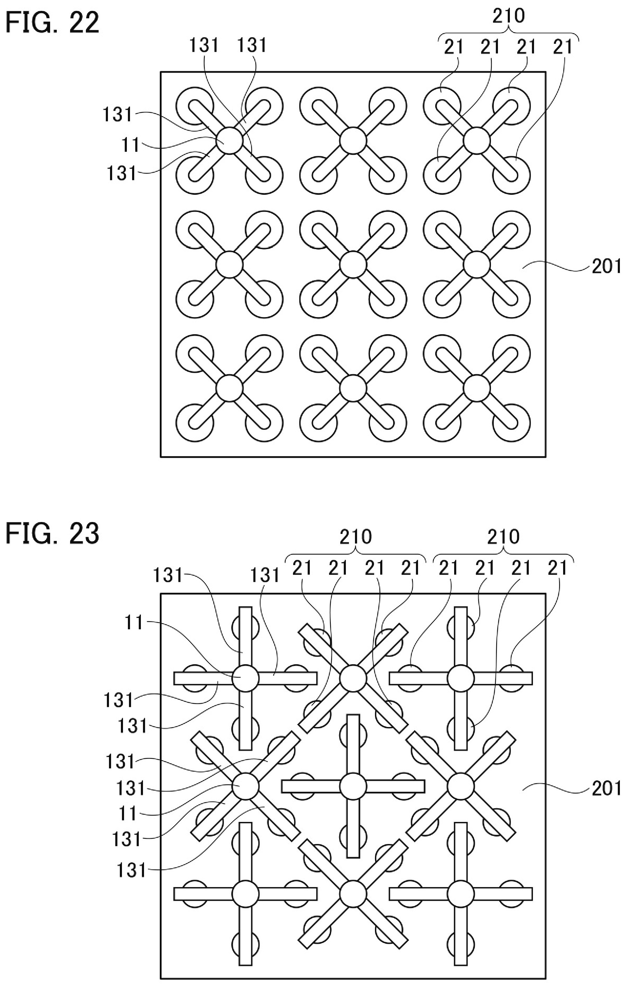

In the electrical connection device 100 according to the second embodiment, as illustrated in FIGS. 20 and 21, the base end portion 13 of the probe 10 includes four connection portions 130. An angle θ formed between the connecting portions 131 of adjacent connection portions 130 may be constant at approximately 90 degrees. Then, as illustrated in FIG. 22, one land group 210 includes four lands 21. The electrical connection device 100 according to the second embodiment differs from the electrical connection device 100 according to the first embodiment in that the base end portion 13 of the probe 10 includes four connection portions 130 and the land group 210 of the substrate 20 includes four lands 21. As for the other configurations, the second embodiment is the same as the first embodiment.

At least one of the four lands 21 included in one land group 210 is electrically connected to the external electrode 22 via, for example, the internal wiring 23, similarly to the substrate 20 illustrated in FIGS. 7 to 9. Alternatively, the land 21 is electrically connected to the external electrode 22 via the surface wiring 24, similarly to the substrate 20 illustrated in FIGS. 10 to 14.

Also, in the electrical connection device 100 according to the second embodiment, the slit 1310 may be formed in the connecting portion 131 of each of the connection portions 130 of the probe 10, similarly to the probe 10 illustrated in FIGS. 15 to 17. Further, the connecting portion 131 of the probe 10 may have a curved portion with elasticity similarly to the probe 10 illustrated in FIG. 18, or may include the first arm 1311a and the second arm 1311b disposed in parallel, similarly to the probe 10 illustrated in FIG. 19.

Also, in the electrical connection device 100 in which one land group 210 includes four lands 21, for example, as illustrated in FIG. 23, between the lands 21 included in one land group 210, at least one land 21 included in another land group 210 may be disposed. Therefore, the electrical connection device 100 in which the distance between the probes 10 is reduced can be configured. The arrangement of the land groups 210 illustrated in FIG. 23 corresponds to a configuration in which adjacent probes 10 are disposed such that the directions in which the connecting portions 131 extend from the body portion 11 differ from each other by 45 degrees. For example, the shape of the surface wiring 24 may be formed so as to overlap with the shape formed by the body portion 11 and the connecting portion 131 of the probe 10 when viewed from the normal direction of the first surface 201.

Otherwise, the electrical connection device 100 according to the second embodiment is substantially the same as in the first embodiment, and redundant description is omitted.

### (Other Embodiments)

Although the present invention has been described by the embodiments as described above, the description and drawings forming a part of this disclosure should not be understood as limiting the present invention. Various alternative embodiments, examples, and operational techniques will be apparent to those skilled in the art from this disclosure.

For example, although the case where the number of connection portions 130 constituting the base end portion 13 is three or four has been described as an example above, the number of connection portions 130 constituting the base end portion 13 may be two. The probes 10 can be disposed closer to each other as the number of connection portions 130 becomes smaller. Further, the number of connection portions 130 constituting the base end portion 13 may be five or more. The allowable value of current flowing through the probe 10 can be set higher as the number of connection portions 130 becomes larger.

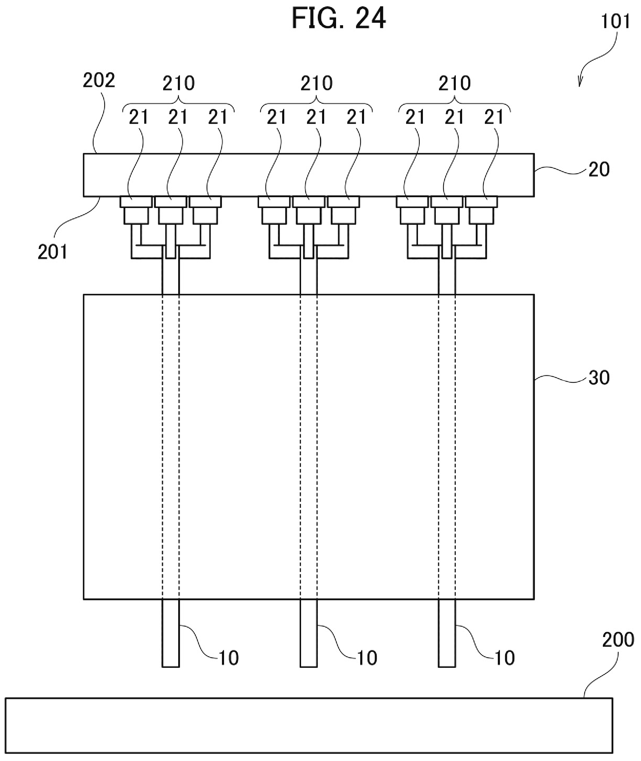

Although the electrical connection device 100 has been described above in which the contact portion 132 of the probe 10 is bonded to the land 21, the electrical connection device may be configured such that the contact portion 132 and the land 21 can freely come into contact with and separate from each other. For example, the probe 10 may be held by the probe head 30 as in the electrical connection device 101 illustrated in FIG. 24. The substrate 20 is disposed adjacent to the probe head 30 in the axial direction. The land 21 is disposed on the first surface 201 of the substrate 20 positioned opposite to the probe head 30.

The probe head 30 may include a guide plate having a plurality of guide holes through which the probes 10 respectively penetrate. The probe head 30 holds the probes 10 in a state where each of the plurality of probes 10 penetrates through a different guide hole. Therefore, adjacent probes 10 can be prevented from coming into contact with each other. Further, by holding the probe 10 with the probe head 30, the contact portion 132 of the probe 10 does not need to be bonded to the land 21. Since the contact portion 132 is not bonded to the land 21, for example, when a defect occurs in the probe 10, the probe 10 can be easily replaced. Further, a stopper having an outer diameter larger than the inner diameter of the guide hole may be formed on the probe 10. When the stopper is hooked on the periphery of the opening of the guide hole of the probe head 30, the probe 10 can be prevented from falling out of the probe head 30.

As described above, it is a matter of course that the present invention includes various embodiments and the like not described above.

The entire contents of Japanese Patent Application No. 2023-209369 (filing date: December 12, 2023) are incorporated herein by reference.

## Claims

1. An electrical connection device used for inspection of electrical characteristics of an inspection object, comprising:
a probe comprising a columnar body portion extending in an axial direction and a base end portion connected to the body portion; and
a substrate having a land disposed on a first surface positioned opposite to the base end portion of the probe, the land being electrically connected to the base end portion, wherein
the base end portion of the probe comprises a plurality of connection portions each having a connecting portion having one end connected to the body portion and a contact portion connected to the other end of the connecting portion, and
the substrate has a land group including a plurality of lands that individually come into contact with each of a plurality of contact portions included in a same base end portion.

2. The electrical connection device according to claim 1, comprising a plurality of probes of the probe, wherein
the substrate includes a plurality of land groups of the land group that are electrically connected to each of the plurality of probes, and
between the lands included in one land group, at least one land included in another land group are disposed.

3. The electrical connection device according to claim 1 or 2, wherein the substrate includes an external electrode electrically connected to at least one of the plurality of lands included in one land group.

4. The electrical connection device according to claim 3, wherein the external electrode is disposed on a second surface of the substrate facing in a direction opposite to the first surface.

5. The electrical connection device according to claim 3, wherein on the first surface of the substrate, the plurality of lands included in the one land group are disposed apart from each other.

6. The electrical connection device according to claim 5, wherein the external electrode is electrically connected to only one of the plurality of lands included in the one land group.

7. The electrical connection device according to claim 5, wherein the plurality of lands included in the land group are electrically connected to each other inside the substrate.

8. The electrical connection device according to claim 3, wherein a surface wiring that electrically connects the plurality of lands included in the one land group to each other is disposed on the first surface of the substrate.

9. The electrical connection device according to claim 8, wherein a width of the surface wiring between the lands is configured not to exceed a diameter of the land when viewed from a normal direction of the first surface.

10. The electrical connection device according to claim 8, wherein a shape of the surface wiring overlaps with a shape formed by the body portion and the connecting portions of the probe when viewed from a normal direction of the first surface.

11. The electrical connection device according to claim 1 or 2, wherein the contact portion of the base end portion of the probe and the land are bonded to each other.

12. The electrical connection device according to claim 1 or 2, wherein an angle formed between adjacent connecting portions connected to the body portion of the probe is the same for all of the adjacent connecting portions when viewed from the axial direction.

13. The electrical connection device according to claim 1 or 2, wherein
the probe includes:
a tip portion connected to one end of the body portion and coming into contact with the inspection object in the inspection; and
the base end portion connected to the other end of the body portion.

14. The electrical connection device according to claim 13, wherein
the connecting portion has elasticity and is connected to the body portion,
a first end of the contact portion is connected to the connecting portion, and
a second end of the contact portion comes into contact with the land.

15. The electrical connection device according to claim 1 or 2, further comprising
a probe head that holds the probe, wherein
the land is disposed on the first surface of the substrate positioned opposite to the probe head.
